# EUROPEAN PATENT SPECIFICATION

(11) **EP 0 583 847 B1**
(45) Date of publication and mention of the grant of the patent: **03.02.1999**
(21) Application number: 93202421.9
(22) Date of filing: 17.08.1993
(51) Int. Cl.: H03J 7/26

(54) **Detection device and receiver for receiving high-frequency signals and comprising such a detection device**
Detektionsanordnung und Empfänger zum Empfang von HF-Signalen mit einer derartigen Detektionsanordnung
Dispositif de détection et récepteur pour signaux à haute fréquence muni d'un tel dispositif

(30) Priority: 18.08.1992 EP 92202519
(43) Date of publication of application: 23.02.1994
(73) Proprietor: Koninklijke Philips Electronics N.V., 5621 BA Eindhoven (NL)
(72) Inventor: Kianush, Kaveh, NL-5656 AA Eindhoven (NL); Egelmeers, Engelbertus Cornelis Joseph, NL-5656 AA Eindhoven (NL); Meeuwis, Johannes Cornelis Maria, NL-5656 AA Eindhoven (NL)
(74) Representative: Mak, Theodorus Nicolaas

(56) References cited:
- EP-A- 0 326 527
- US-A- 3 936 753
- PATENT ABSTRACTS OF JAPAN vol. 9, no. 118 (E-316)(1841) 23 May 1985 & JP-A-60 007 222 (SONY K.K.)

## Description

The invention relates to a detection device for detecting a tuning state of a high-frequency modulated signal within a frequency band, comprising an output for supplying an in-channel signal indicating whether a desired tuning state has been reached, which detection device comprises a window comparator having an input for receiving a filtered, demodulated version of the high-frequency modulated signal, and an input for receiving a level signal which is a measure for a level of the high-frequency modulated signal, the in-channel signal being formed, by means of a combination device, from output signals of the window comparator and from the level signal.

The invention also relates to a receiver for receiving high-frequency signals and comprising such a detection device. Such a receiver may be a radio receiver, a television receiver, a video recorder or a cordless or mobile telephone.

A detection device of this kind for the detection of a tuning state of a high-frequency modulated signal within a frequency band is known from Japanese Patent Application No. 58-115419, Kokai 60-7222/85. The known detection device, intended to reduce so-called muting in an FM receiver, comprises a window comparator whereto there is applied a filtered, demodulated version of a high-frequency modulated signal to be applied to the FM receiver, and also comprises an input for receiving a level signal which is supplied by a level device which is included in the FM receiver and which serves to determine a level signal which is a measure for the level of the high-frequency modulated signal. The known detection device also comprises a combination device which is formed by two gates whereby an in-channel signal is formed from output signals of the window comparator and from the level signal. The in-channel signal is applied to control means which are not shown in the cited Kokai. It is known that the detector characteristic of a detector such as an FM detector is S-shaped if the RF frequency sweeps around a frequency whereto the tuner is tuned. This characteristic is referred to as the so-called S-curve. The window comparator, consisting of two comparator circuits with hysteresis, imposes two detection thresholds on the S-curve, so that it can be determined whether the filtered demodulated version of the high-frequency modulated signal is around a signal zero level between the two detection thresholds. In order to avoid that the detection device does not provide an in-channel indication if no station is received, *i.e.* if there is no RF signal, level information of the RF signal is also taken into account. AND-combination of the signals from the S-curve detection and the level detection then produces an in-channel signal. In a search mode, pulses from the detection device can be filtered, if desired, in order to obtain a suitably defined in-channel signal. A problem encountered during use of the known detection device in *inter alia* the search mode in an FM receiver consists in that incorrect in-channel signals may be generated, which incorrect signals may cause tuning to a "wrong" slope of the S-curve where no station is situated; this may occur notably in the event of a frequency band comprising many stations where stations may be situated very near to one another. This is because the level signal may then be situated between two stations above the adjusted detection thresholds, because intermediate frequency filters do not adequately suppress the adjacent channels. In practical cases the S-curve will also be distorted in the event of a busy frequency band. Moreover, the requirements imposed on the low-pass filter preceding the detection device will vary in the preset mode and the search mode, and choosing a compromise may give rise to an increased number of mistunings. Measurements have shown that wrong slopes of the S-curve over the frequency band tend to be steeper than correct slopes, so that incorrect in-channel pulses generally are shorter than correct in-channel pulses. When use is made of a filter connected to the output of the detection device, requirements which are more difficult to combine are then also imposed on this filter. The compromise to be chosen in this respect may also lead to an increased number of mistunings.

It is the object of the invention to provide a detection device for the detection of a tuning state of a high-frequency modulated signal within a frequency band which is reliable and accurate and which does not give rise to any mistuning or at least minimizes the number of mistunings.

A detection device in accordance with the invention is characterized in that the detection device comprises a differentiation device, including an input for receiving the filtered demodulated high-frequency signal, and that the combination device forms the in-channel signal by combining the output signals of the window comparator, the level signal and a signal to be supplied by the differentiation device. In the search mode, the described variation of the S-curve over the frequency band is utilized, *i.e.* a slope-sensitive detection is achieved by differentiation, thus enabling discrimination between incorrect and correct in-channel signals or pulses.

Because the solution to the above problem by slope differentiation does not produce a reliable in-channel signal in all R signal circumstances, a further, preferred detection device in accordance with the invention is characterized in that the detection device comprises a slope detection device for slope detection of the filtered, demodulated high-frequency signal, which slope detection device is coupled to the window comparator, and that the combination device forms the in-channel signal also from a signal to be supplied by the slope detection device. Thus, a very reliable detection device is obtained which is not critically dependent on time constants to be chosen, *i.e.* the time constants to be chosen can be chosen so as to be optimum. The invention is based on the idea that during an up-search, a comparator having a higher reference level in the window comparator supplies a logic signal "1" sooner than a comparator having a lower reference level supplies a logic signal "0" for a correct slope, whereas for a wrong slope the comparator of lower reference level supplies a logic signal "1" before the comparator of higher reference level supplies a logic signal "0", *i.e.* the slope detection is actually based on the phase relation between the output signals of the comparators. A similar signal behaviour occurs during a down-search, be it inverted with respect to an up-search.

A further embodiment of a detection device in accordance with the invention is characterized in that the slope detection device is a phase comparator. The phase comparator is capable of identifying said phase relation.

A further embodiment of a detection device in accordance with the invention, for use of the detection device in a search mode of a receiver, is characterized in that reference signals of the window comparator are adjustable, in the search mode and for a first value of the in-channel signal the reference signals being adjusted to a window which is narrower than after termination of the search mode and for a second value of the in-channel signal. In a two-loop tuning system as included in a receiver as described in the simultaneously filed European Patent Application No. 92202520.0 better cooperation between the loop systems is thus possible. This is because an excessively wide window in the search mode would lead to overshoot to a station other than the desired station. An additional advantage of such an adjustment resides in the fact that less annoyance is experienced from audio modulation and that the detection device is capable of generating a correct in-channel signal on the basis of only one, non-critical time constant, being the time constant of the filter preceding the detection device.

The invention will be described in detail hereinafter with reference to a drawing; therein:
Fig. 1 shows a block diagram of a receiver in accordance with the invention,
Fig. 2 shows a first embodiment of a detection device in accordance with the invention,
Fig. 3 shows a second embodiment of a detection device in accordance with the invention,
Fig. 4 shows signals in a detection device as shown in Fig. 3 as a function of time, and
Fig. 5 shows the switching of reference signals in a detection device as shown in Fig. 3.

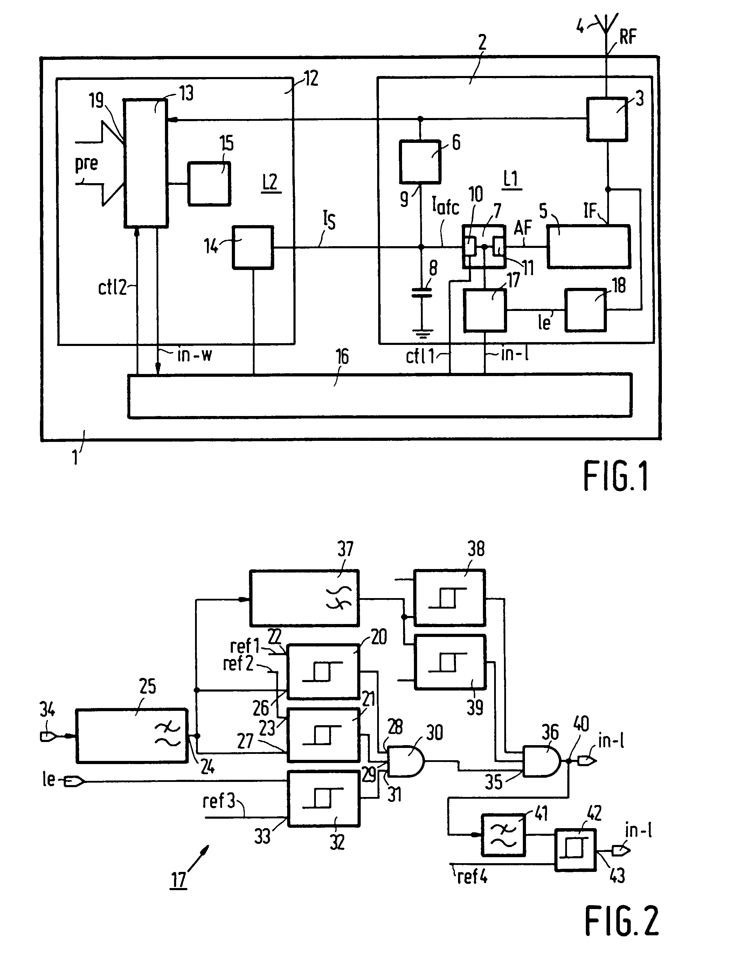

Fig. 1 shows a block diagram of a receiver 1 in accordance with the invention. The receiver 1 comprises a receiving section 2 which includes a first frequency loop L1 with a frequency conversion device 3 for frequency conversion of a high-frequency modulated signal RF, to be applied to the receiving section 2 *via* an aerial 4, into a modulated signal IF of lower frequency. The frequency loop L1 also comprises a detection device 5 for detection of an information signal present in the modulated signal of lower frequency IF, for example a radio or television broadcast signal or a telephone signal, and a tuning oscillator 6 which is coupled to the frequency conversion device 3 and whose frequency can be adjusted by means of a first tuning control signal I_{afc} to be supplied by a first tuning control signal generator 7 coupled to the detection device 5. The tuning control signal generator may comprise a controlled current source 10 which applies a tuning control signal I_{afc} in the form of a current to a loop filter 8, preferably an integrator, which is formed, for example by a capacitor for integration of the current I_{afc}, so that there is formed a control voltage ∫ I_{afc}.dt for supply to a control input 9 for controlling the tuning oscillator 6, being a VCO (Voltage Controlled Oscillator) in the present embodiment. The tuning control signal generator 7 also comprises a low-pass filter 11 which filters an output signal of the detection device 5, for example an FM discriminator, and outputs it as a control signal for the controlled current source 10. In a superheterodyne receiver the frequency conversion device 3 may be a customary mixing stage for mixing the high-frequency modulated signal RF so as to form the modulated signal of lower frequency IF, being an intermediate frequency, for example 10.7 MHz in the event of broadcast FM. Conventional selective intermediate frequency amplifiers comprising fixed filter sections, then present in the receiving section 2, are assumed to be included in the detection device 5 for the sake of simplicity. Other customary structures are also feasible for the receiving section 2, for as long as a suitable control signal can be applied to the tuning oscillator 6 for frequency tuning thereof in the first frequency loop L1. The invention is not restricted to FM signals, other modulation types such as AM and PM, also being feasible. In addition to a superheterodyne structure, for example a receiving section 2 based on a so-called direct-conversion structure which is very well suitable for integration is also feasible. In order to minimize tuning errors in the receiving section 2, *per se,* caused by DC offsets and leakage currents in the AFC loop, the current source 10 should have a very high output impedance; this can be achieved, for example by choosing a so-called Wilson current mirror configuration in which an input current is applied to a conventional current mirror configuration but an output current is supplied *via* an output transistor in cascode connection with a mirror transistor. The input current of the current source 10, supplied *via* the low-pass filter 11, can then be delivered by a voltage/current converter (not shown) coupled to symmetrical outputs of the detector 5 (not shown herein). The receiver also comprises a tuning section 12 which includes a second frequency loop L2 with a frequency measuring device 13 for measuring the frequency of the tuning oscillator 6, and a second tuning control signal generator 14 which can be coupled to the frequency measuring device 13 and which serves to generate a second tuning control signal Iₛ to be applied to the tuning oscillator 6. A measured frequency of the tuning oscillator 6 can be stored in a last-channel memory 15. The receiver also comprises a control device 16 for controlling the receiving section 2 and the tuning section 12. In the preset mode (preset tuning) of the receiver 1, the control device 16 will control and/or open or close the first and/or the second frequency loop L1 and L2, *i.e.* in this mode both frequency loops L1 and L2 are active. During operation of the receiver 1 in the search mode (autosearch tuning), in given circumstances only the first frequency loop L1 is active, the frequency measuring device 13 being used to measure the frequency of the relevant station after a station has been found. The control device 16 can close the frequency loop L1 at least in dependence on a first control signal in-l (in-lock signal) to be supplied by the receiving section 2. Depending on the mode of operation of the receiver 1, the control device 16 controls the first and/or the second frequency loop L1 and L2 also on the basis of a second control signal in-w (in-window signal) to be applied to the control device 16 by the frequency measuring device 13. The in-lock signal in-1 is formed, by a in-lock detection device 17, from the AFC signal from the detection device 5, filtered by the low-pass filter 11, and from a level signal le which can be supplied by a level device 18 and which is a measure for the level of the high-frequency modulated signal RF. The in-lock detection device 17 supplies a reliable in-lock signal, indicating that the first frequency loop has been adjusted with a given accuracy, by very accurate analysis of the so-called S-curve. The control device 16 also supplies control signals ct11 and ct12 to the current source 10 and the frequency measuring device 13 for respective control and on/off switching. The control device can also autonomously control the second tuning control signal generator 14, which may be a controllable charge pump having several control inputs, in the autosearch mode. The frequency measuring device 13 may be a programmable counter having a preset input 19 for receiving a digital preset signal pre which can be supplied by a microprocessor (not shown) or also, in a simple and inexpensive embodiment of the receiver 1 in accordance with the invention, by a hardware preset device consisting of a number of flipflop registers. Such a simple embodiment can be implemented in comparatively inexpensive portable radio receivers. The presets can be adjusted during the autosearch mode or also *via* a frequency which can be entered *via* a keyboard and which is loaded into the preset registers after having been digitized. For a more elaborate description of the receiver 1, reference is made to the simultaneously filed European Patent Application No. 9220252.0.

Fig. 2 shows a first embodiment of a detection device for detecting a tuning state of a high-frequency modulated signal, *i.e.* an in-lock detection device 17 in accordance with the invention. The detection device 17 comprises a window comparator which is formed by two comparators 20 and 21 with hysteresis and with reference signals on inputs 22 and 23, said comparator being connected at its input side to an output 24 of a low-pass filter 25 which applies a filtered, demodulated version of the high-frequency modulated signal RF to inputs 26 and 27 of the comparators 20 and 21. The comparators 20 and 21 with hysteresis may be so-called Schmitt triggers. At their output side the comparators 20 and 21 are connected to inputs 28 and 29 of an AND-gate 30, an input 31 of which receives the level signal le, again *via* a comparator 32 with hysteresis, said level signal being a measure for a level of the high-frequency modulated signal RF. The sensitivity of the detection device can be adjusted *via* a reference signal ref3 to be applied to an input 33 of the comparator 32. An input 34 of the low-pass filter 25 receives a demodulated version of the high-frequency modulated signal RF, being a signal AF from the detector 5. The filter 25 of the detection device 17 corresponds to the filter 11 of Fig. 1. The AND-gate 30 is connected at its output side to an input 35 of an AND gate 36 whereto there is also coupled a differentiation device which is formed by a high-pass filter 37 and two Schmitt triggers 38 and 39 for detection of a version of the input signal of the window comparator which has been differentiated by the high-pass filter 37. The in-channel or in-lock signal in-l is available at an output 40 of the AND-gate 36 or, *via* a low-pass filter 41 which is coupled to the output 40 and a Schmitt trigger 42 which is coupled thereto, at an output 43 of the Schmitt trigger 42 which also receives a reference signal ref4. Thus, the in-channel signal in-l is formed, by a combination device consisting of the AND-gates 30 and 36, from output signals of the window comparator, from the level signal le, and from a differentiated version of the filtered, demodulated high-frequency signal. In this respect use is made of the fact that wrong slopes in the S-curve over a frequency band, *i.e.* slopes between stations in the frequency band on which the detection device would produce an incorrect in-channel signal, generally tend to be steeper than correct slopes in the S-curve, *i.e.* slopes on which a signal is situated. This embodiment has the drawback that, as has already been described, a reliable in-lock signal is not obtained in all signal circumstances of the signal RF.

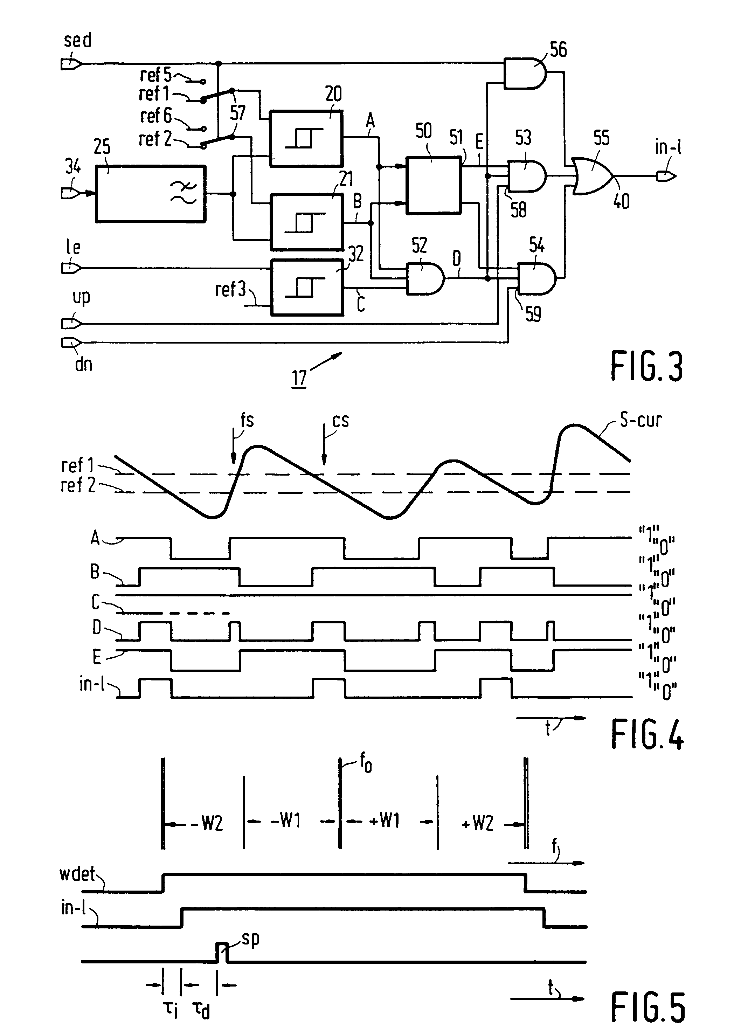

Fig. 3 shows a second, preferred embodiment of a detection device 17 in accordance with the invention. Therein, signals and devices corresponding to Fig. 2 are denoted by corresponding references. The comparators 20 and 21 supply signals A and B which are applied to a phase comparator 50, commercially available as a circuit MC4044, a output 51 of which supplies a signal E. The combination device in accordance with the invention for combining the output signals A and B of the window comparator, the level signal le and output signals of the phase comparator 50, is formed by AND-gates 52, 53 and 54 and by an OR-gate 55. An AND-gate 56, also forming part of the combination device, can receive a control signal sea in order to enable operation of the detection device 17 in the search mode, as described, with two sets of reference signals: ref1 and ref2, and ref6, respectively. The control signal sea controls a switch 57.

Fig. 4 shows the signals A, B, C, D, E and in-l in a detection device 17 as shown in Fig. 3 as a function of time t and also an S-curve S-cur over a frequency band which is so busy that S-curves of individual stations influence one another. The reference signals ref1 and ref2 of the window comparator 20, 21 are represented in the variation S-cur of the S-curve. The signal C, being a digital representation of the level signal le, always has the logic value "1" in the present embodiment because the level signal le does not decrease sufficiently between stations in the case of a busy frequency band. The operation of the detection device shown in Fig. 3 will be described with reference to the signal behaviour in Fig. 4, which also shows a correct slope cs and a wrong slope fs. During an up-search in the frequency band towards a station, the output signal A of the comparator 20 becomes logic "1", in the event of a correct slope cs, before the output signal B of the comparator 21 becomes logic "0", whereas in the event of a wrong slope fs the output signal B of the comparator 21 becomes logic "1" before the output signal A of the comparator 20 becomes logic "0". During a down-search, these signals exhibit a similar behaviour, be it in the reverse sense. Thus, the phase relation between the signals A and B, detected by the phase comparator 50, is the key to slope detection. It is to be noted that the signal D varies like in the detection device known from Kokai 60-7222/85, that is to say with incorrect "in-lock" pulses, whereas the in-lock signal in-1 in accordance with the invention does not contain incorrect in-lock pulses. In order to ensure that the correct in-channel or in-lock signals are generated during an up-search and a down-search, the combination device in the detection device 17 comprises inputs 58 and 59 for receiving enable signals up and dn, respectively, to enable up-search and down-search.

Fig. 5 shows the switching of reference signals in a detection device as shown in Fig. 3 by means of the control signal sea whereby the window comparator 20, 21 can be adjusted in the search mode. Above signals as function of time t, including the in-channel signal in-l, frequency windows are shown as a function of frequency f. The search mode will be described hereinafter with reference to a receiver 1 as shown in Fig. 1. It is assumed that a frequency window -W2, +W2 of the window comparator, situated around a desired tuning frequency f₀, is 40 kHz and that a frequency window of the frequency loop L2 in Fig. 2 is 20 kHz as may be the case in the event of FM. As soon as the in-lock signal in-l appears in the receiver 1 in the search mode, which signal is delayed by an amount of τᵢ relative to the "real" window detection signal wdet due to the filter 25, the search mode is stopped and the AFC loop L1 should adjust the tuning oscillator 6 to the desired tuning frequency f₀. After a brief delay τ_{d}, for example 50 ms, subsequent to the beginning of the in-lock signal in-1, frequency measurement by the frequency measuring device 13 commences as indicated by a start pulse sp. It may then occur that the AFC loop L1 has not yet pulled the frequency of the tuning oscillator 6 within the frequency window of the preset mode, so that the frequency measuring device 13 measures a frequency which is more than 20 kHz removed from the desired tuning frequency f₀. This is not problematic for as long as no fading is involved, but in the case of fading the in-lock signal in-l temporarily disappears, the preset mode loop L2 is activated and the frequency of the tuning oscillator 6 is adjusted, by the last-channel memory 15, to the frequency measured in the search mode. The AFC loop L1 will then tend to tune to the frequency f₀, but because the frequency deviation amounts to more than 20 kHz, no in-window signal in-w will be generated; the latter signal should be present in the receiver 1 shown in Fig. 1 in order to stop the tuning process, so that the loop L2 remains active and the detector signal AF in the receiver 1 remains "mute". When a narrower windower window -W1, +W1 is chosen, for example 8.8 kHz, during the search mode, the above problem can be avoided and, moreover, the S-curve can be filtered more and interference due to audio modulation in the detector 5 is also reduced. The cut-off frequency of the filter 25 is, for example 80 Hz or less and the in-lock signal in-1 can be generated in the presence of only one non-critical time constant. In the search mode, the reference signals ref5 and ref6 are switched on, corresponding to a narrower frequency window, and as soon as the in-lock signal in-1 is present, the reference signals ref1 and ref2 are activated, corresponding to a wider frequency window.

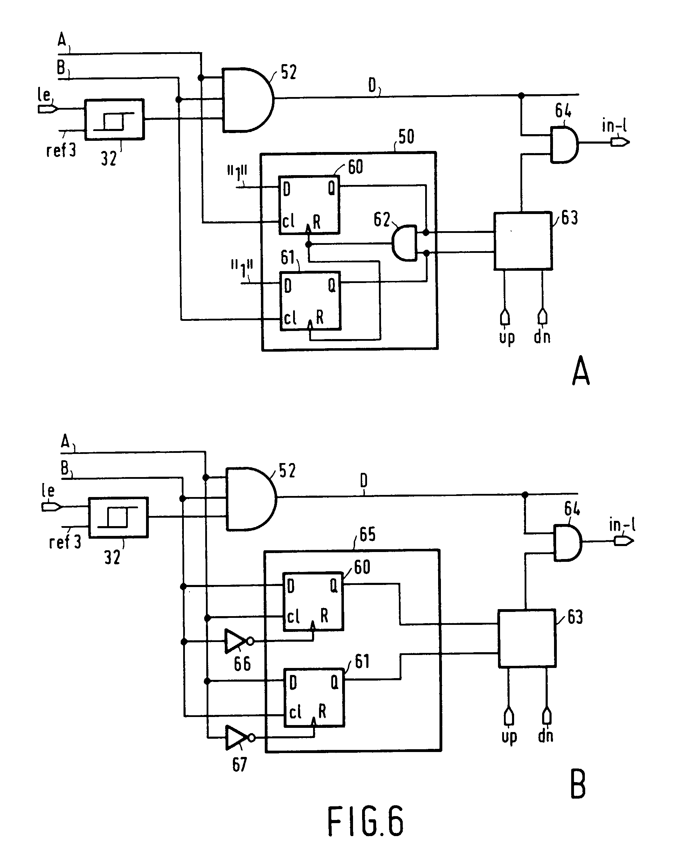

Fig. 6A shows a further elaboration of a part of the second embodiment of a detection device 17 in accordance with the invention as shown in Fig. 3. The further elaboration concerns the phase comparator 50 which comprises a first D-flipflop 60, a second D-flipflop 61, and an AND-gate 62. The flipflops 60 and 61 comprise inputs D, cl and R and an output Q. The D-input of the flipflop 60 receives a logic "'1" signal and its clock input c1 receives the signal A. The D-input of the flipflop 61 receives a logic "1" signal and its clock input cl receives the signal B. At the output side, outputs of the phase comparator are connected to respective outputs Q of the flipflops 60 and 61, which outputs also apply, via the AND-gate 62, reset signals to the respective reset inputs of the flipflops 60 and 61. Also shown are a multiplexer 63 and an AND-gate 64, replacing the gates 53, 54 and 55 of Fig. 3. The operation of the circuit shown in Fig. 6A corresponds to that of the corresponding part of Fig. 3.

Fig. 6B shows a modification of the part of the circuit of Fig. 3 which is shown in Fig. 6A. Shown is a modified phase comparator 65 which comprises, like the phase comparator 50, the flipflops 60 and 61 but not the AND-gate 62. In Fig. 6B the D-input of the flipflop 60 receives the signal B and its R-input or reset input receives the inverse of the signal B, derived from the signal by means of an inverter 66. The D-input of the flipflop 61 receives the signal A and its R-input receives the inverse of the signal A which is obtained by inversion of the signal A By means of an inverter 67. It is thus achieved that, in contrast with the non-modified phase detector 50, the operation of the flipflops 60 and 61 is fully independent. Such independent operation is necessary when the S-curve is distorted to such an extreme that the S-curve signal exceeds the reference signal ref1 but not the reference signal ref2, as shown in Fig. 4, and vice versa. In the event of such strong distortion of the S-curve, the phase comparator 65 does not have this drawback. One flipflop in the modified phase comparator 65 then detects the S-curve entering the window formed by the references ref1 and ref2 in a given direction, and the Q-output thereof remains high until the S-curve leaves the window in the same direction; the other flipflop performs the same function, be it in the opposite direction.

## Claims

1. A detection device (17) for detecting a tuning state of a high-frequency modulated signal (RF) within a frequency band, comprising an output (40; 43) for supplying an in-channel signal (in-1) indicating whether a desired tuning state has been reached, which detection device (17) comprises a window comparator (20, 21) having an input for receiving a filtered, demodulated version of the high-frequency modulated signal, an input for receiving a level signal (1e) which is a measure for a level of the high-frequency modulated signal (RF), and a differentiation device (37, 38, 39), including an input for receiving the filtered demodulated high frequency signal, the in-channel signal (in-1) being formed by means of a combining device (30, 36) from the output signals of the window comparator (20, 21), a signal representative of the level signal (1e), and a signal to be supplied by the differentiation device (37, 38, 39).

2. A detection device for detecting a tuning state of a high frequency modulated signal (RF) within a frequency band, comprising an output (40) for supplying an in-channel signal (in-1) indicating whether a desired tuning state has been reached, which detection device (17) comprises a window comparator (20, 21) having an input for receiving a filtered, demodulated version of the high-frequency modulated signal, an input for receiving a level signal (1e) which is a measure for a level of the high-frequency modulated signal (RF), and a slope detection device (50) for slope detection of the filtered, demodulated high-frequency signal, which slope detection device (50) is coupled to the window comparator (20, 21), the in-channel signal (in-1) being formed by means of a combining device (52, 53, 54, 55) from the output signals of the window comparator (20, 21), a signal representative of the level signal (1e), and a signal to be supplied by the slope detection device (50).

3. A detection device (17) as claimed in Claim 2, characterized in that the slope detection device is a phase comparator (50).

4. A detection device as claimed in Claim 2 or 3, for use of the detection device (17) in a search mode of a receiver (1) for receiving high-frequency signals, characterized in that reference signals (ref1, ref2; ref5, ref6) of the window comparator (20, 21) are adjustable, in the search mode and for a first value of the in-channel signal ("0"), the reference signals being adjusted, to a window (ref5, ref6) which is narrower than after termination of the search mode and for a second value ("1") of the in-channel signal.

5. A receiver (1) for receiving high-frequency signals, comprising a frequency conversion device (3) for frequency conversion of a high-frequency modulated signal (RF), a detector (5) for detecting a baseband signal from a frequency-converted version (IF) of the high-frequency modulated signal (RF), a level device (18) for determining a level signal (1e) which is a measure for the level of the high-frequency modulated signal (RF), and a detection device as claimed in any one of the preceding Claims, which receiver (1) also comprises a control device (16) having an input for receiving the in-channel signal (in-1) in order to control a tuning oscillator (6) coupled to the frequency conversion device (3).

## Patentansprüche

1. Detektionsanordnung (17) zum Detektieren eines Abstimmzustandes eines HF-modulierten Signals (RF) innerhalb eines Frequenzbandes, mit einem Ausgang (40; 43) zum Liefern eines In-Kanal-Signals (in-1), das angibt, ob ein gewünschter Abstimmzustand erreicht worden ist, wobei diese Detektionsanordnung (17) einen Fenstervergleicher (20, 21) mit einem Eingang zum Zuführen einer gefilterten, demodulierten Version des HF-modulierten Signals aufweist, und mit einem Eingang zum Zuführen eines Pegelsignals (1e), das ein Maß ist für einen Pegel des HF-modulierten Signals (RF), und mit einer Differenzieranordnung (37, 38, 39) mit einem Eingang zum Empfangen des gefilterten, demodulierten HF-Signals, wobei das In-Kanal-Signal (in-1) mittels einer Kombinieranordnung (30, 36) aus dem Ausgangssignal des Fenstervergleichers (20, 21) aus einem Signal, repräsentativ für das Pegelsignal (1e) und einem Signal, das von der Differenzieranordnung (37, 38, 39) geliefert werden soll, gebildet wird.

2. Detektionsanordnung zum Detektieren eines Abstimmzustandes eines HF-modulierten Signals (RF) innerhalb eines Frequenzbandes, mit einem Ausgang (40) zum Liefern eines In-Kanal-Signals (in-1), das angibt, ob ein gewünschter Abstimmzustand erreicht worden ist, wobei diese Detektionsanordnung (17) einen Fenstervergleicher (20, 21) mit einem Eingang zum Empfangen einer gefilterten, demodulierten Vcrsion des HF-modulierten Signals aufweist, und mit einem Eingang zum Empfangen eines Pegelsignals (1e), das ein Maß ist für einen Pegel des HF-modulierten Signals (RF), und mit einer Neigungsdetektionsanodnung (50) zur Neigungsdetektion des gefilterten, demodulierten HF-Signals, wobei diese Neigungsdetektionsanordnung (50) mit dem Fenstervergleicher (20, 21) gekoppelt ist, wobei das In-Kanal-Signal (in-1) mittcls einer Kombinieranordnung (52, 53, 54, 55) aus den Ausgangssignalen des Fenstervergleichers (20, 21), einem Signal, das repräsentativ ist für das Pegelsignal (1e) und einem Signal, das von der Neigungsdetektionsanordnung (50) geliefert werden soll, gebildet wird.

3. Detektionsanordnung (17) nach Anspruch 2, dadurch gekennzeichnet, daß die Neigungsdetektionsanordnung ein Phasenvergleicher (50) ist.

4. Detektionsanordnung nach Anspruch 2 oder 3, zum Gebrauch der Detektionsanordnung (17) in einer Suchlauf-Mode eines Empfängers (1) zum Empfangen von HF-Signalen, dadurch gekennzeichnet, daß die Bezugssignale (ref1, ref2; ref5, ref6) des Fenstervergleichers (20, 21) einstellbar sind in der Suchlauf-Mode und für einen ersten Wert des In-Kanal-Signals ("0"), wobei die Bezugssignale einstellbar sind auf ein Fenster (ref5, ref6), das kleiner ist als nach Beendigung der Suchlauf-Mode und für einen zweiten Wert ("1") des In-Kanal-Signals.

5. Empfänger (1) zum Empfangen von HF-Signalen mit einem Frequenzwandler (3) zur Frequenzumwandlung eines HF-modulierten Signals (RF), einem Detektor (5) zum Detektieren eines Basisbandsignals aus einer frequenzverwandelten Version (IF) des HF-modulierten Signals (RF), einer Pegelanordnung (18) zum Bestimmen eines Pegelsignals (1e), das ein Maß ist für den Pegel des HF-modulierten Signals (RF), und einer Detektionsanordnung nach einem der vorstehenden Ansprüche, wobei dieser Empfänger (1) ebenfalls eine Steueranordnung (16) aufweist mit einem Eingang zum Empfangen des In-Kanal-Signals (in-1) zur Steuerung eines Abstimmoszillators (6), der mit dem Frequenzwandler (3) gekoppelt ist.

## Revendications

1. Dispositif de détection (17) pour détecter un état d'accord d'un signal modulé à haute fréquence (RF) à l'intérieur d'une bande de fréquences, comprenant une sortie (40; 43) pour fournir un signal en voie (in-1) indiquant si un état d'accord souhaité a oui ou non été atteint, lequel dispositif de détection (17) comprend un comparateur de fenêtres (20, 21) comportant une entrée pour recevoir une version filtrée et démodulée du signal modulé à haute fréquence, une entrée pour recevoir un signal de niveau (1e) qui est une mesure d'un niveau du signal modulé à haute fréquence (RF), et un dispositif de différenciation (37, 38, 39), comportant une entrée pour recevoir le signal démodulé et filtré à haute fréquence, le signal en voie (in-1) étant formé au moyen d'un dispositif de combinaison (30, 36) à partir des signaux de sortie du comparateur de fenêtres (20, 21), d'un signal représentatif du signal de niveau (1e), et d'un signal à fournir par le dispositif de différenciation (37, 38, 39).

2. Dispositif de détection pour détecter un état d'accord d'un signal modulé à haute fréquence (RF) à l'intérieur d'une bande de fréquences, comprenant une sortie (40) pour fournir un signal en voie (in-1) indiquant si un état d'accord souhaité a oui ou non été atteint, lequel dispositif de détection (17) comprend un comparateur de fenêtres (20, 21) comportant une entrée pour recevoir une version filtrée et démodulée du signal modulé à haute fréquence, une entrée pour recevoir un signal de niveau (1e) qui est une mesure d'un niveau du signal modulé à haute fréquence (RF), et un dispositif de détection de pente (50) pour détecter la pente du signal démodulé et filtré à haute fréquence, lequel dispositif de détection de pente (50) est couplé au comparateur de fenêtres (20, 21), le signal en voie (in-1) étant formé au moyen d'un dispositif de combinaison (52, 53, 54, 55) à partir des signaux de sortie du comparateur de fenêtres (20, 21), d'un signal représentatif du signal de niveau (1e), et d'un signal à fournir par le dispositif de détection de pente (50).

3. Dispositif de détection (17) suivant la revendication 2, caractérisé en ce que le dispositif de détection de pente est un comparateur de phase (50).

4. Dispositif de détection suivant la revendication 2 ou 3, pour une utilisation du dispositif de détection (17) en un mode de recherche d'un récepteur (1) afin de recevoir des signaux à haute fréquence, caractérisé en ce que les signaux de référence (ref1, ref2; ref5, ref6) du comparateur de fenêtres (20, 21) sont réglables, en mode de recherche et pour une première valeur du signal en voie ("0"), les signaux de référence étant réglés sur une fenêtre (ref5, ref6) qui est plus étroite qu'après la clôture du mode de recherche et pour une deuxième valeur ("1") du signal en voie.

5. Récepteur (1) destiné à recevoir les signaux à haute fréquence, comprenant un dispositif de changement de fréquence (3) pour le changement de fréquence d'un signal modulé à haute fréquence (RF), un détecteur (5) pour détecter un signal de bande de base à partir d'une version changée en fréquence (IF) du signal modulé à haute fréquence (RF), un dispositif de niveau (18) pour déterminer un signal de niveau (1e) qui est une mesure du niveau du signal modulé à haute fréquence (RF), et un dispositif de détection suivant l'une quelconque des revendications précédentes, lequel récepteur (1) comprend également un dispositif de commande (16) comportant une entrée pour recevoir le signal en voie (in-1) afin de commander un oscillateur d'accord (6) couplé au dispositif de changement de fréquence (3).
